# EUROPEAN PATENT APPLICATION

(11) **EP 4 262 185 A1**
(43) Date of publication of application: **18.10.2023**
(21) Application number: 21902029.4
(22) Date of filing: 20.07.2021
(51) Int. Cl.: H04N 5/232, H05K 9/00

(54) **CAMERA**

(30) Priority: 08.12.2020 CN 202011424877
(71) Applicant: Hangzhou Hikvision Digital Technology Co., Ltd., Hangzhou, Zhejiang 310051 (CN)
(72) Inventor: GU, Yubin, Hangzhou, Zhejiang 310051 (CN)
(74) Representative: Epping - Hermann - Fischer
(86) International application number: PCT/CN2021/107353
(87) International publication number: WO 2022/121318

(57) **Abstract**

The present disclosure provides a camera device, which relates to the field of security monitoring. The camera device comprises: a fixed body provided with a power supply board; a rotating body, rotatably connected to the fixed body; a camera, mounted on the rotating body; a control board, mounted on the rotating body and electrically connected to the camera; a first wireless module, connected to the fixed body and electrically connected to the power supply board; a second wireless module, mounted on the rotating body and electrically connected to the control board; and a first shielding case, mounted on the rotating body, and arranged, in a covering manner, outside at least one of the first wireless module and the second wireless module. The above solution can solve the problem of low security when an existing camera device uses wireless slip-ring communication.

## Description

The present application claims priority to a Chinese patent application No. 202011424877.5 filed with the China National Intellectual Property Administration (CNIPA) on December 08, 2020 and entitled "Camera Device", which is incorporated herein by reference in its entirety.

### Technical Field

The present application relates to the field of security monitoring, and in particular to a camera device.

### Background

The camera device is a representative of the development of modern television monitoring, integrating multiple devices such as color integrated cameras, pan tilt, decoders, protective covers, etc. Furthermore, the camera device is easy to install, easy to use, and powerful in function, and is widely used in various monitoring situations.

The existing internal data communication methods for the camera device mainly includes a wired slip-ring communication and a wireless slip-ring communication. The wireless slip-ring communication can effectively solve the problems of friction torque, short life, poor electromagnetic interference resistance, and unstable communication that exist in the wired slip-ring communication. Therefore, the wireless slip-ring communication is gradually applied to various camera devices. However, the wireless slip-ring communication may encounter problems such as signal leakage and easy interception of signal transmission, resulting in low security when the existing camera devices use the wireless slip-ring communication.

### Summary

The purpose of embodiments of the present application is to provide a camera device that can solve the problem of low security when an existing camera device uses wireless slip-ring communication.

In order to solve the above technical problems, the present application is implemented as follows.

An embodiment of the present application provides a camera device, including:
a fixed body, wherein the fixed body is provided with a power supply board;
a rotating body, wherein the rotating body is rotatably connected to the fixed body;
a camera, wherein the camera is mounted on the rotating body;
a control board, wherein the control board is mounted on the rotating body, and the control board electrically connected to the camera;
a first wireless module, wherein the first wireless module is connected to the fixed body, and the first wireless module is electrically connected to the power supply board;
a second wireless module, wherein the second wireless module is mounted on the rotating body, and the second wireless module is electrically connected to the control board;
a first shielding case, wherein the first shielding case is mounted on the rotating body, and the first shielding case is arranged outside at least one of the first wireless module and the second wireless module and covers the at least one of the first wireless module and the second wireless module.

In the embodiment of the present application, the power supply board can be powered on to drive the camera to work. When the rotating body drives the second wireless module to rotate, the fixed body, the power supply board, and the first wireless module are all stationary. At this time, the wired signal is transmitted to the first wireless module through the power supply board, and the first wireless module then transmits the wireless signal to the second wireless module through wireless communication, thereby controlling the camera for related operations. Alternatively, the camera transmits data to the control board, which then transmits the data to the first wireless module through the second wireless module in a wireless manner, thereby achieving a communication between the camera and the power supply board. Since the first shielding case is arranged on the first wireless module and/or the second wireless module, the risk of signal interception between the first wireless module and the second wireless module can be reduced, and thereby improving the safety of wireless communication of the camera device.

### Brief Description of the Drawings

In order to more clearly describe the technical solution of the embodiments of the present application and the prior art, drawings needed in the embodiments and the prior art will be briefly described below. Obviously, the drawings described below are for only some embodiments of the present application, one of ordinary skills in the art can also obtain other embodiments based on the drawings illustrated herein without any creative efforts.
Fig. 1 is a cross-sectional view of the camera device disclosed in an embodiment of the present application;
Fig. 2 is a partially enlarged structural view of Fig. 1;
Fig. 3 is a schematic structural view of a first wireless module disclosed in an embodiment of the present application;
Fig. 4 is a schematic structural view of a second wireless module disclosed in an embodiment of the present application;
Fig. 5 is a schematic structural view of a shielding range of a second shielding case disclosed in another embodiment of the present application;

### Reference Signs:

110 - fixed body, 111 - power supply board;
120 - rotating body;
130 - camera;
140 - control board;
150 - first wireless module, 151 - wireless transceiver, 152 - attenuator, 153 - antenna, 154 - low noise amplifier, 155 - radio frequency switch, 156 - second shielding case, 157 - transmission link, 158 - reception link;
160 - second wireless module;
170 - first shielding case;
171 - case body, 171a - first perforation, 171b - third perforation;
172 - base plate, 172a - second perforation, 172b - fourth perforation;
180 - connector;
190 - electrical connector, 191 - rigid member, 192 - flexible member;
200 - first cable, 210 - second cable;
220 - first drive mechanism, 230 - second drive mechanism, 240 - top cover.

### Detailed Description

In order to make objectives, technical solutions and advantages of the present application more apparent, the present application now will be described in detail with reference to the accompanying drawings and by way of examples. Obviously, the embodiments described are only some of the embodiments of the present application instead of all of them. All other examples obtained by those skilled in the art based on the examples herein without any creative efforts fall into the scope of protection defined by the present disclosure.

The terms such as "first", "second" and the like in the description and claims of the present application are used to distinguish similar objects, and are not used to describe a specific order or sequence. It should be understood that the data used in this way can be interchanged in appropriate cases, so that the embodiments in the present application can be implemented in order other than those illustrated or described here, and the objects distinguished by "first", "second", etc. are usually of the same class and do not limit the number of the objects. For example, the first object can be one or multiple. In addition, in the description and claims, "and/or" represents at least one of the connected objects, and the character "/" generally indicates that the objects associated before and after are in an "or" relationship.

The camera device provided in embodiments of the present application will be described in detail through specific embodiments and their application scenarios, by combining with the accompanying drawings.

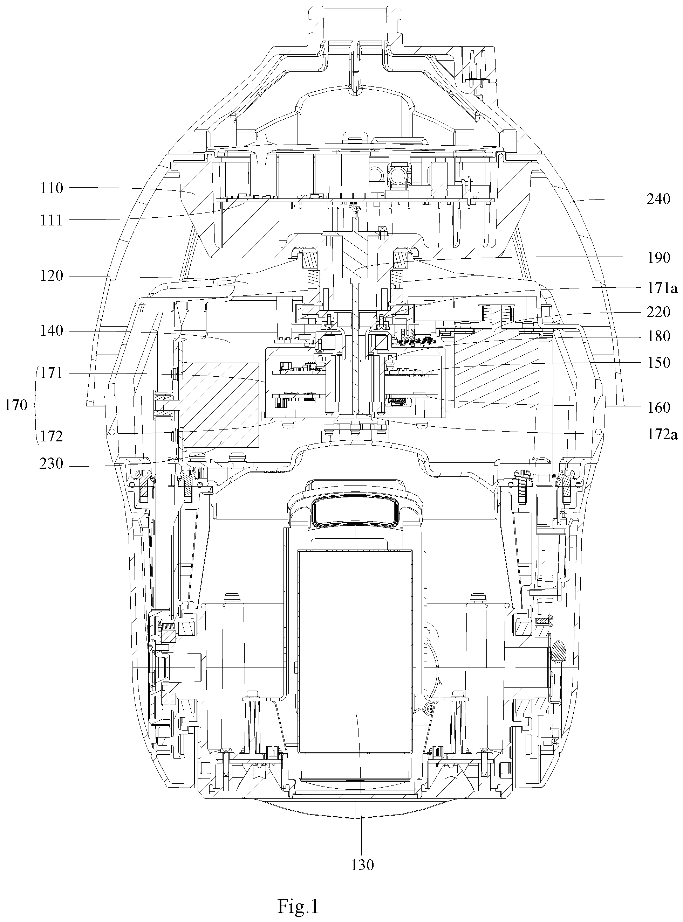

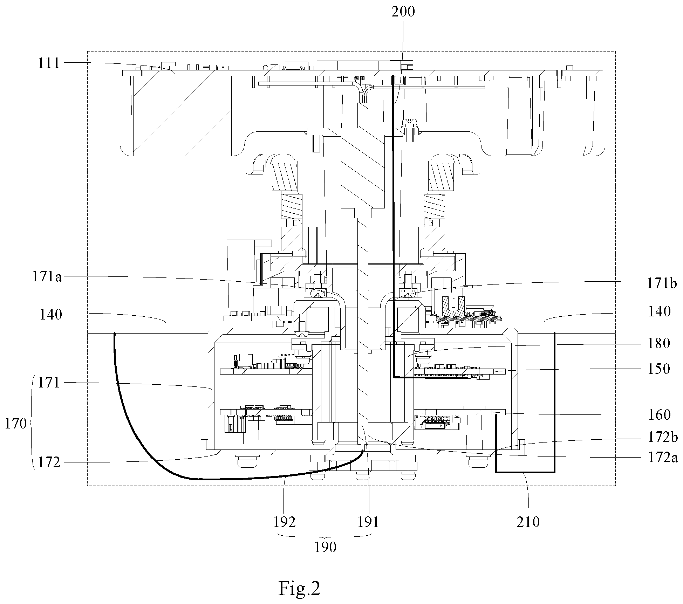

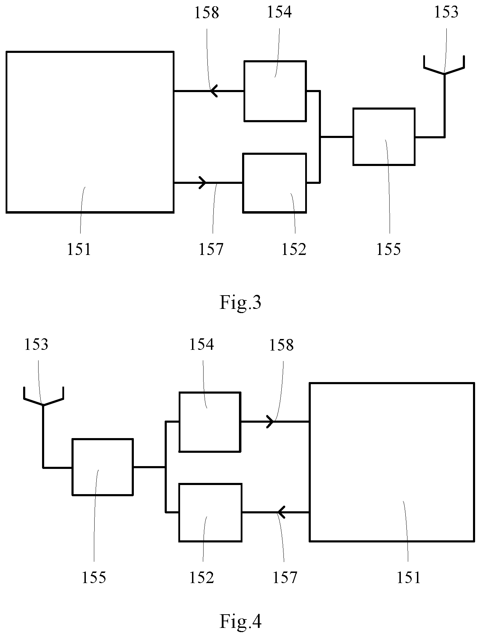

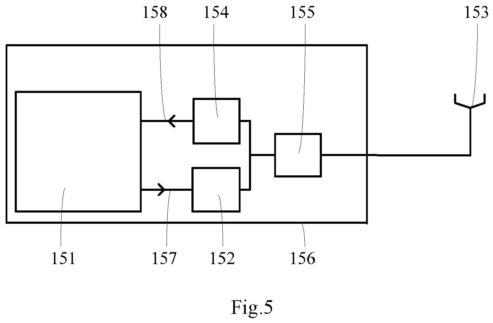

As shown in Figs. 1 to 5, the embodiments of the present application disclose a camera device, which includes a fixed body 110, a rotating body 120, a camera 130, a control board 140, a first wireless module 150, a second wireless module 160, a first shielding case 170, a first drive mechanism 220, a second drive mechanism 230, and a top cover 240.

The top cover 240 is arranged above the fixed body 110, and the top cover 240 has a protective function, and its main function is to prevent damage to the fixed body 110 and the rotating body 120 during installation or transportation. The fixed body 110 and the rotating body 120 can be components made of metal materials, the fixed body 110 and rotating body 120 made of metal have good rigidity and signal shielding, making them less prone to damage and reducing the risk of signal interception; the fixed body 110 is arranged with a power supply board 111, which can provide power for the operation of the camera device; the rotating body 120 is rotatably connected to the fixed body 110; the camera 130 is mounted on the rotating body 120 and follows the rotation of the rotating body 120, which can monitor the surrounding environment in a wide range; the control board 140 is mounted on the rotating body 120, and the control board 140 is electrically connected to the camera 130, the control board 140 can also be referred to as a pan tilt board; the first wireless module 150 is connected to the fixed body 110, and the first wireless module 150 is electrically connected to the power supply board 111; the second wireless module 160 is mounted on the rotating body 120, and the second wireless module 160 is electrically connected to the control board 140; the first shielding case 170 is mounted on the rotating body 120, and the first shielding case 170 is arranged outside at least one of the first wireless module 150 and the second wireless module 160 and covers the at least one of the first wireless module 150 and the second wireless module 160, wherein the first shielding case 170 can be a component made of metal material. The fixed body 110, the rotating body 120, and the first shielding case 170 made of metal materials can better achieve a signal shielding, and thereby improve the safety of the wireless communication inside the camera device. The metal materials here can be copper, aluminum, iron, etc., but are not limited to the fixed body 110, rotating body 120, and first shielding case 170 made of these metal materials. The first drive mechanism 220 can drive the rotating body 120 connected to the fixed body 110 to rotate around a first axis which can extend along a horizontal direction. The second drive mechanism 230 can drive the camera 130 to rotate around a second axis which can extend along a vertical direction. The first drive mechanism 220 and the second drive mechanism 230 herein can include a motor or other components with a driving function, and the embodiments of the present application do not limit this. Optionally, the first drive mechanism 220 and the second drive mechanism 230 may include a motor and a pulley accessory connected to the motor, which transmits a driving force through the pulley accessory to achieve the rotation of the camera 130.

In the embodiments of the present application, the power supply board 111 can be powered on to drive the camera device to work. When the rotating body 120 drives the second wireless module 160 to rotate, the fixed body 110, the power supply board 111, and the first wireless module 150 are all stationary. At this time, the wired signal is transmitted to the first wireless module 150 through the power supply board 111, and the first wireless module 150 then transmits the wireless signal to the second wireless module 160 through wireless communication, thereby controlling the camera 130 for related operations. Alternatively, the camera 130 transmits data to the control board 140, the control board 140 then transmits the data to the first wireless module 150 through the second wireless module 160 in a wireless manner, thereby achieving a communication between the camera 130 and the power supply board 111. Since the first shielding case 170 is arranged on the first wireless module 150 and/or the second wireless module 160, the risk of signal interception between the first wireless module 150 and the second wireless module 160 can be reduced, and thereby improving the safety of wireless communication of the camera device.

In one embodiment, the first wireless module 150 and the second wireless module 160 are arranged opposite to each other, both of which are located within the first shielding case 170. Through the above arrangement, the signal transmission distance between the first wireless module 150 and the second wireless module 160 can be shortened, thereby improving the stability of wireless communication. The first wireless module 150 and the second wireless module 160 are both arranged within the first shielding case 170, so that the first wireless module 150 and the second wireless module 160 are within the shielding range of the first shielding case 170, thereby improving the shielding effect and making the signal less easily intercepted during communication, and thus improving the security of the wireless communication.

In a further embodiment, the first shielding case 170 includes a case body 171 and a base plate 172. One end of the case body 171 is an open end, and the base plate 172 blocks the open end. The first wireless module 150 and the second wireless module 160 are both located within the case body 171. The operator can firstly assemble the first wireless module 150, second wireless module 160, and other components through the open end of the first shielding case 170, and then block the open end with the base plate 172 to form a closed first shielding case 170 in conjunction with the case body 171. Therefore, by arranging the case body 171 and the base plate 172, on the one hand, it is convenient for the operator to assemble the first wireless module 150, second wireless module 160, and other components of the camera device, and on the other hand, the first shielding case 170 formed by the case body 171 and the base plate 172 can better protect the wireless communication between the first wireless module 150 and the second wireless module 160, and thereby improve the safety of the wireless communication.

In one embodiment, the camera device further includes a connector 180, the connector 180 is connected to a fixed body 110, and the connector 180 is located within the case body 171. The case body 171 and the base plate 172 are both rotatably connected to the connector 180. The first wireless module 150 is mounted on the connector 180, and the second wireless module 160 is mounted on the base plate 172. When the first drive mechanism 220 drives the rotating body 120 to rotate, as the fixed body 110 is relatively stationary and the connector 180 is connected to the fixed body 110, the first wireless module 150 mounted on the connector 180 is also stationary, and the rotating body 120 drives the case body 171 and the base plate 172 to rotate. The second wireless module 160 is mounted on the base plate 172, so the second wireless module 160 is rotated relative to the first wireless module 150 which is stationary. It follows that the internal structure of the camera device is more compact and simple, by connecting the fixed body 110 and the rotating body 120 via the connector 180 to achieve the rotation of the second wireless module 160 relative to the first wireless module 150.

In another embodiment, the camera device also includes an electrical connector 190. A first perforation 171a is arranged on the case body 171, a second perforation 172a is arranged on the base plate 172. One end of the electrical connector 190 is connected to the power supply board 111, and the other end of the electrical connector 190 passes through the first perforation 171a and the second perforation 172a and is connected to the control board 140. Optionally, the electrical connector 190 can include a rigid member 191 and a flexible member 192. One end of the rigid member 191 is connected to the power supply board 111, the other end of the rigid member 191 is connected to one end of the flexible member 192, and the other end of the flexible member 192 is connected to the control board 140. The connection method of connecting one end of the electrical component 190 to the power supply board 111 and the other end to the control board 140 can maximize the efficiency of utilizing the internal space of the camera device without any additional space for wiring layout, and thus the internal structure of the camera device is more compact.

In an optional embodiment, the camera device also includes a first cable 200. A third perforation 171b is arranged on the case body 171. One end of the first cable 200 is connected to the power supply board 111, and the other end of the first cable 200 passes through the third perforation 171b and is connected to the first wireless module 150. The connection method of connecting the one end of the first cable 200 to the power supply board 111 and the other end to the first wireless module 150 can maximize the efficiency of utilizing the internal space of the camera device without any additional space for wiring layout, and thus the internal structure of the camera device is more compact. In addition, when the first perforation 171a is arranged on the case body 171, the first perforation 171a and the third perforation 171b can be the same perforation or different perforations, and the embodiments of the present application do not limit this. When the first perforation 171a and the third perforation 171b are the same perforation, it can further reduce the signal leakage and make it easier to process the case body 171.

In another optional embodiment, the camera device also includes a second cable 210. A fourth perforation 172b is arranged on the base plate 172. One end of the second cable 210 is connected to the control board 140, and the other end of the second cable 210 passes through the fourth perforation 172b and is connected to the second wireless module 160. The connection method of connecting the one end of the second cable 210 to the control board 140 and the other end to the second wireless module 160 can maximize the efficiency of utilizing the internal space of the camera device without any additional space for wiring layout, and thus the internal structure of the camera device is more compact.

The leakage of signals during communication is mainly reflected in the high transmission power. Therefore, at least one of the first wireless module 150 and the second wireless module 160 includes a wireless transceiver 151, an attenuator 152, and an antenna 153. A transmission link 157 is arranged between the wireless transceiver 151 and the antenna 153, and the attenuator 152 is arranged on the transmission link 157. By arranging the attenuator 152 on the transmission link 157, the transmission power can be reduced, thereby reducing the risk of signal interception during transmission between the first wireless module 150 and the second wireless module 160, thereby improving the safety of signal transmission. In addition, the internal chip parameters of the wireless transceiver 151 can also be set to reduce the transmission power of the chip transmitter, thereby further reducing the risk of leakage during wireless signal transmission.

In a further optional embodiment, the attenuator 152 is a π-type attenuator. The π-type attenuator can adjust the size of the signal more regularly, so as to be more beneficial to reduce the transmission power of the first wireless module 150 and the second wireless module 160.

However, whether using the attenuator 152 to reduce the transmission power or setting the internal chip parameters of the wireless transceiver 151 to reduce the transmission power, when the transmission power of the first wireless module 150 and the second wireless module 160 is reduced to a certain extent, the stability of signal transmission between the first wireless module 150 and the second wireless module 160 will be affected. Therefore, at least one of the first wireless module 150 and the second wireless module 160 includes a wireless transceiver 151, a low noise amplifier 154, and an antenna 153. A reception link 158 is arranged between the wireless transceiver 151 and the antenna 153, and the low noise amplifier 154 is arranged on the reception link 158. The low noise amplifier 154 can improve the reception sensitivity of the wireless transceiver 151 by utilizing its own low noise performance, and thus is more suitable for arranging in situations where weak signals are amplified. Therefore, by arranging the low noise amplifier 154 on the reception link 158, the reception sensitivity of the first wireless module 150 and the second wireless module 160 can be improved, thereby compensating for the impact of the low transmission power and achieving complementary transmission and reception performance when the first wireless module 150 and the second wireless module 160 communicate with each other, thereby improving the stability of wireless communication.

When the transmission powers of the first wireless module 150 and the second wireless module 160 are reduced to the certain extent, the external radiation signal of the antenna 153 is weaker, while the external radiation signals of the first wireless module 150, the second wireless module 160, the transmission link 157, the reception link 158, and other components are stronger, which becomes the main source of the wireless signal leakage. Therefore, at least one of the first wireless module 150 and the second wireless module 160 includes a wireless transceiver 151, a radio frequency switch 155, an antenna 153, and a second shielding case 156, and a transmission link 157 and a reception link 158 are arranged between the wireless transceiver 151 and the radio frequency switch 155, and the second shielding case 156 is arranged outside at least one of the wireless transceiver 151, the transmission link 157, the reception link 158, and the radio frequency switch 155 and covers the at least one of the wireless transceiver 151, the transmission link 157, the reception link 158, and the radio frequency switch 155. The antenna 153 is located outside the second shielding case 156. Such arrangement can reduce the radiation of signals other than the antenna 153, thereby further reducing the source of the wireless signal leakage. The embodiments of the present application adopt a dual shielding case structure of the first shielding case 170 and the second shielding case 156, which can achieve good shielding effect for the entire camera device, effectively reduce the signal leakage, and thus achieve the high isolation.

In an optional embodiment, camera 130 is a spherical camera. The spherical camera can allow external light to enter the camera device more evenly, and facilitate to convert light signals. Meanwhile, the spherical camera can expand the viewing range, thereby improving the monitoring effect.

The above are only preferred embodiments of the present disclosure and are not intended to limit the present disclosure. Any modifications, equivalent substitutions, improvements, etc., which are made within the spirit and principles of the present application, will fall into the protection scope of the present application.

## Claims

1. A camera device, comprising:
a fixed body (110), wherein the fixed body (110) is provided with a power supply board (111);
a rotating body (120), wherein the rotating body (120) is rotatably connected to the fixed body (110);
a camera (130), wherein the camera (130) is mounted on the rotating body (120);
a control board (140), wherein the control board (140) is mounted on the rotating body (120), and the control board (140) is electrically connected to the camera (130);
a first wireless module (150), wherein the first wireless module (150) is connected to the fixed body (110), and the first wireless module (150) is electrically connected to the power supply board (111);
a second wireless module (160), wherein the second wireless module (160) is mounted on the rotating body (120), and the second wireless module (160) is electrically connected to the control board (140);
a first shielding case (170), wherein the first shielding case (170) is mounted on the rotating body (120), and the first shielding case (170) is arranged outside at least one of the first wireless module (150) and the second wireless module (160) and covers the at least one of the first wireless module (150) and the second wireless module (160).

2. The camera device as claimed in claim 1, wherein the first wireless module (150) and the second wireless module (160) are arranged opposite to each other, both of which are located within the first shielding case (170).

3. The camera device as claimed in claim 2, wherein the first shielding case (170) comprises a case body (171) and a base plate (172); one end of the case body (171) is an open end, and the base plate (172) blocks the open end; the first wireless module (150) and the second wireless module (160) are both located within the case body (171).

4. The camera device as claimed in claim 3, wherein the camera device further comprises a connector (180), the connector (180) is connected to the fixed body (110), and the connector (180) is located within the case body (171); the case body (171) and the base plate (172) are rotatably connected to the connector (180); and the first wireless module (150) is mounted on the connector (180), and the second wireless module (160) is mounted on the base plate (172).

5. The camera device as claimed in claim 3, wherein the camera device further comprises an electrical connector (190); a first perforation (171a) is arranged on the case body (171), a second perforation (172a) is arranged on the base plate (172); one end of the electrical connector (190) is connected to the power supply board (111), and the other end of the electrical connector (190) passes through the first perforation (171a) and the second perforation (172a) and is connected to the control board (140).

6. The camera device as claimed in claim 5, wherein the electrical connector (190) comprises a rigid member (191) and a flexible member (192); one end of the rigid member (191) is connected to the power supply board (111), the other end of the rigid member (191) is connected to one end of the flexible member (192), and the other end of the flexible member (192) is connected to the control board (140).

7. The camera device as claimed in claim 3, wherein the camera device also comprises a first cable (200); a third perforation (171b) is arranged on the case body (171); one end of the first cable (200) is connected to the power supply board (111), and the other end of the first cable (200) passes through the third perforation (171b) and is connected to the first wireless module (150).

8. The camera device as claimed in claim 3, wherein the camera device further comprises a second cable (210); a fourth perforation (172b) is arranged on the base plate (172); one end of the second cable (210) is connected to the control board (140), and the other end of the second cable (210) passes through the fourth perforation (172b) and is connected to the second wireless module (160).

9. The camera device as claimed in claim 1, wherein at least one of the first wireless module (150) and the second wireless module (160) comprises a wireless transceiver (151), an attenuator (152), and an antenna (153); and a transmission link (157) is arranged between the wireless transceiver (151) and the antenna (153), and the attenuator (152) is arranged on the transmission link (157).

10. The camera device as claimed in claim 9, wherein the attenuator (152) is a π-type attenuator.

11. The camera device as claimed in claim 1, wherein at least one of the first wireless module (150) and the second wireless module (160) comprises a wireless transceiver (151), a low noise amplifier (154), and an antenna (153); and a reception link (158) is arranged between the wireless transceiver (151) and the antenna (153), and the low noise amplifier (154) is arranged on the reception link (158).

12. The camera device as claimed in claim 1, wherein at least one of the first wireless module (150) and the second wireless module (160) comprises a wireless transceiver (151), a radio frequency switch (155), an antenna (153), and a second shielding case (156); a transmission link (157) and a reception link (158) are arranged between the wireless transceiver (151) and the radio frequency switch (155); the second shielding case (156) is arranged outside at least one of the wireless transceiver (151), the transmission link (157), the reception link (158), and the radio frequency switch (155) and covers the at least one of the wireless transceiver (151), the transmission link (157), the reception link (158), and the radio frequency switch (155), and the antenna (153) is located outside the second shielding case (156).

13. The camera device as claimed in claim 1, wherein the camera (130) is a spherical camera.
